# EUROPEAN PATENT APPLICATION

(11) **EP 4 775 718 A1**
(43) Date of publication of application: **15.07.2026**
(21) Application number: 25224404.1
(22) Date of filing: 17.12.2025
(51) Int. Cl.: C30B 25/20, C30B 29/36, C30B 33/02, C30B 25/12, C30B 29/60, C23C 16/32

(54) **SEMICONDUCTOR HEAT TREATMENT MEMBER**

(30) Priority: 27.12.2024 JP 2024231565; 30.10.2025 JP 2025183278
(71) Applicant: CoorsTek GK, Tokyo 141-0032 (JP)
(72) Inventor: Inoue, Masatoshi, Yamagata, 999-1351 (JP)
(74) Representative: Grünecker Patent- und Rechtsanwälte PartG mbB

(57) **Abstract**

A semiconductor heat treatment member includes: a substrate containing carbon or silicon carbide; and a CVD-SiC film with which a surface of the substrate is covered, a surface of the CVD-SiC film is an unprocessed surface, the CVD-SiC film has an average particle diameter of SiC particles of at least 60 µm, and the CVD-SiC film has a surface roughness Sa of at least 3.5 µm, and contains SiC particles having a flat surface of at least 3,600 µm².

## Description

### CROSS-REFERENCE TO RELATED APPLICATION

This application is based on and claims priority under 35 USC 119 from Japanese Patent Application No. 2024-231565 filed on December 27, 2024 and Japanese Patent Application No. 2025-183278 filed on October 30, 2025.

### TECHNICAL FIELD

The present invention relates to a semiconductor heat treatment member such as a susceptor that supports a wafer in an epitaxial film forming apparatus, and a method for producing the same.

### BACKGROUND ART

As a pretreatment for forming a semiconductor circuit on a silicon (Si) wafer or a silicon carbide (SiC) wafer, there is a step of forming an epitaxial film on the wafer.

In general, in the step of forming the epitaxial film on the Si wafer, for example, a susceptor (semiconductor heat treatment unit) in which a carbon substrate is covered with SiC as described in Patent Literature 1 is used.

In general, the epitaxial film is grown at 1,250°C or lower on the Si wafer. When the epitaxial film is grown on the Si wafer, polysilicon is also deposited on the susceptor.

This polysilicon is to be removed (cleaned) periodically by a high-temperature treatment using a reducing gas such as hydrogen chloride (HCl), and a dimensional change or particle generation caused by polysilicon deposition on the susceptor is reset.

Patent Literature 1: JPH11-157989A

### SUMMARY OF INVENTION

Incidentally, there is a case where the deposited polysilicon is not completely removed and remains in a grain boundary or the like of a SiC film. Then, there is a concern that the polysilicon that cannot be removed hinders Si epitaxial growth or hinders a high quality of the wafer.

In general, since the SiC film covering a surface of a semiconductor heat treatment member is composed of various large and small polycrystals, a desorption rate of the polysilicon cannot be controlled, and it is difficult to completely remove the polysilicon entering the grain boundary with high efficiency.

On the other hand, when the cleaning using the reducing gas such as hydrogen chloride (HCl) is excessively performed in order to completely remove the deposited polysilicon, the SiC film covered on the carbon substrate is eroded, the member is damaged, and replacement of the member is required in some cases.

In order to solve the above technical problems, the present inventors have intensively studied a semiconductor heat treatment member capable of easily and more completely removing polysilicon deposited on a semiconductor heat treatment member such as a susceptor in a process using Si such as a Si epitaxial process and using a reducing gas such as hydrogen chloride (HCl), and have completed the present invention.

An object of the present invention is to provide a semiconductor heat treatment member capable of easily removing polysilicon from a SiC film.

A semiconductor heat treatment member according to an aspect of the present application includes: a substrate comprising carbon or silicon carbide; and a CVD-SiC film with which a surface of the substrate is covered, wherein a surface of the CVD-SiC film is an unprocessed surface, the CVD-SiC film has an average particle diameter of SiC particles of at least 60 µm, and the CVD-SiC film has a surface roughness Sa of at least 3.5 µm, and contains SiC particles having a flat surface of at least 3,600 µm².

In the semiconductor heat treatment member including such a CVD-SiC film, polysilicon can be easily removed from the SiC film.

In this regard, the CVD-SiC film preferably has the SiC particles grown in a columnar shape from the surface of the substrate.

According to the present invention, it is possible to obtain a semiconductor heat treatment member capable of easily removing the polysilicon from the CVD-SiC film.

### BRIEF DESCRIPTION OF DRAWINGS

Fig. 1 is a diagram showing a particle state of a CVD-SiC film in a semiconductor heat treatment member according to the present invention.
Fig. 2 is a schematic diagram showing the CVD-SiC film in the semiconductor heat treatment member according to the present invention.

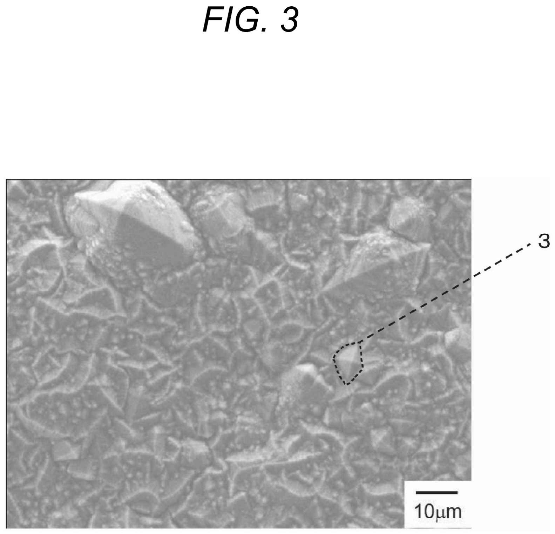

Fig. 3 is a diagram showing a particle state of a CVD-SiC film in a semiconductor heat treatment member in the related art.

### DESCRIPTION OF EMBODIMENTS

Hereinafter, a semiconductor heat treatment member according to one embodiment of the present invention will be described.

The present invention relates to a semiconductor heat treatment member in which a surface of a substrate made from carbon or silicon carbide is covered with a CVD-SiC film, and particularly to a semiconductor heat treatment member in which polysilicon deposited on a SiC film can be easily removed from the SiC film in a step of forming an epitaxial film on a wafer or the like.

As a result, when the semiconductor heat treatment member of the present invention is used, a high quality epitaxial layer can be obtained.

The semiconductor heat treatment member is, for example, a susceptor and a peripheral member thereof (a lift pin, a ring member, or the like), a vertical boat, a horizontal boat, and a peripheral member thereof (a pedestal, a heat insulating plate, a dummy wafer, or the like), which are ceramic members supporting a Si wafer or a SiC wafer. A substrate used for the semiconductor heat treatment member is made from silicon, carbon such as graphite, and silicon carbide. Among them, a substrate made from carbon is suitably used because it is low in cost and processing difficulty.

In the present embodiment, a susceptor including a substrate made from carbon (carbon substrate) and a SiC film on a surface of the substrate will be described as a semiconductor heat treatment member used to grow an epitaxial layer on a surface of a wafer.

As the carbon substrate, a carbon (isotropic high purity graphite, manufactured by CoorsTek GK) substrate is used as in a method in the related art.

The carbon substrate is preferably formed to have a substrate thickness of 1.0 mm to 20.0 mm and a diameter of 50 mm to 400 mm (for a 4, 5, 6, 8, or 12-inch Si wafer), and a content of each of metal elements (Fe, Ni, and Cr) is preferably 0.05 ppm or less.

When each of the contents of the metal elements (Fe, Ni, and Cr) of the substrate is 0.05 ppm or less, it is possible to prevent a reaction between the CVD-SiC film covering the surface of the substrate and metal impurities contained in the substrate, and erosion and wear, and thus it is possible to keep the function as a semiconductor heat treatment member long and to prevent occurrence of resistance abnormality and defects in the treated wafer.

The surface of the carbon substrate contains a polymorphic crystal containing 3C-SiC as the CVD-SiC film obtained by crystal growth by using a CVD method.

In this regard, SiC has many polymorphisms due to a difference in stacking order. Representative polymorphisms include 3C-SiC, 2H-SiC, and 4H-SiC. The 3C-SiC is a cubic crystal, and the 2H-SiC and the 4H-SiC are hexagonal crystals.

The 3C-SiC cubic crystal has peaks corresponding to (111), (311), (200), (220), and (222) by X-ray diffraction. Having such peaks means that a good crystal is formed by epitaxial growth of SiC. Note that, the X-ray diffraction is diffraction using X-rays (CuKα rays) of 40 keV.

In forming the CVD-SiC film, a binary raw material including a Si source containing Si for SiH₄ and a C source containing C for CH₄ is used as a raw material, and keep coating is performed at a temperature of 1,100°C to 1,500°C under a furnace pressure of 0.10 Torr to 0.40 Torr. The keep coating means a coating time in a state where the temperature is kept constant during the film forming period.

Note that, as the raw material, SiCl₄ can also be used as the Si source and C₃H₈ can also be used as the C source.

In addition, a vacuum pump capable of maintaining a degree of vacuum to 0.10 Torr or less during temperature rise is used. At the start of film formation, the furnace pressure is controlled to 0.30 Torr to 0.40 Torr, and the film formation is performed through the keep coating while reducing the pressure from 0.10 Torr to 0.20 Torr.

This film forming treatment is additionally performed 1 to 7 times to obtain a total of 2 to 8 CVD-SiC films. The surface roughness and the particle diameter vary depending on the number of layers, and two or more layers are preferred.

Finally, a susceptor is obtained in which the average particle diameter of the SiC particles is 60 µm or more, the SiC surface roughness Sa is 3.5 µm or more, SiC particles having a flat surface of 3,600 µm² or more are contained, and SiC particles grown in a columnar shape from the surface of the substrate are covered on the surface.

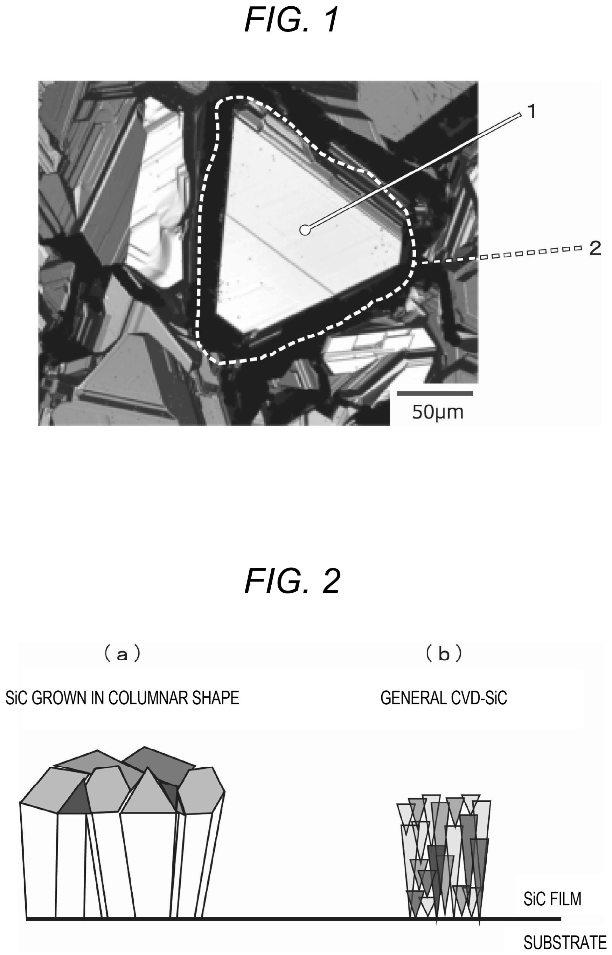

In this manner, when the surface of the CVD-SiC film is an unprocessed surface, the average particle diameter of the SiC particles is 60 µm or more, the SiC surface roughness Sa is 3.5 µm or more, and the CVD-SiC film is a CVD-SiC film in which the SiC particles are grown in a columnar shape from the surface of the substrate as shown in (a) of Fig. 2, polysilicon deposited on the SiC film can be easily removed. Note that, (b) of Fig. 2 shows the case of a general CVD-SiC film.

Therefore, it is possible to easily remove the polysilicon from the CVD-SiC film, which causes a decrease in yield of a Si epitaxial process or a decrease in quality of the epitaxial layer, and to obtain a high quality epitaxial layer.

More specifically, in the susceptor including the CVD-SiC film, a thickness of the CVD-SiC film is preferably at least 80 µm. When the thickness of the CVD-SiC film is 80 µm or more, deformation of the susceptor during use at a high temperature can be prevented, and there is no deformation of the susceptor or exposure of the substrate due to consumption of the CVD-SiC film, resulting in a long life.

In addition, since the average particle diameter of the SiC particles in the CVD-SiC film in the susceptor including the CVD-SiC film is at least 60 µm, the number of SiC grain boundaries can be reduced.

When the average particle diameter of the SiC particles in the CVD-SiC film is less than 60 µm, the number of SiC grain boundaries increases, and accordingly, contaminants are taken in from a metal member such as SUS or stainless steel when a cleaning gas is transported from the outside into a reaction vessel, and resistance to chemical erosion derived from impurities caused by adhesion of the contaminants to the susceptor during cleaning decreases, which is not preferred.

In addition, when the average particle diameter of the SiC particles in the CVD-SiC film is less than 60 µm, a flat surface of 3,600 µm² or more is difficult to be present, there are many SiC grain boundaries, and it is difficult to remove the polysilicon deposited on the SiC film.

Note that, the average particle diameter in the present invention is calculated as an arithmetic mean of measured values of a plurality of particles obtained by measuring the maximum diameter of each particle (the diameter of a circumscribed circle of the particle) using image analysis software based on an image acquired by using a laser microscope at a magnification of 20.

In addition, since the surface roughness Sa of the CVD-SiC film in the susceptor including the CVD-SiC film is at least 3.5 µm, the CVD-SiC film is in point contact with the wafer and is less likely to stick to the wafer. When the surface roughness Sa of the CVD-SiC film is less than 3.5 µm, there is a concern that the CVD-SiC film sticks to the wafer, which is not preferred. Note that, when the surface roughness Sa of the CVD-SiC film is too large, stress concentration is likely to occur, and there is a concern that defects such as slip are induced, so that the surface roughness Sa is more preferably 10.0 µm or less.

In addition, when the surface roughness Sa of the CVD-SiC film is larger than 10 µm, the CVD-SiC film and a polysilicon film adhere to each other and it is difficult to remove the polysilicon deposited on the CVD-SiC film.

The surface roughness Sa of the CVD-SiC film is calculated based on shape data obtained by acquiring a three-dimensional shape of a surface to be measured using a non-contact optical surface shape measuring apparatus. Note that, a commercially available laser scanning microscope is used for the measurement, but the type of the apparatus is not limited thereto. Sa is an arithmetic mean height according to ISO 25178.

As shown in Fig. 1, the CVD-SiC film in the susceptor including the CVD-SiC film contains SiC particles 1 having a flat surface of at least 3,600 µm². In this manner, since the SiC particles having a flat surface of at least 3,600 µm² are contained, surface energy is low, reactivity is poor, and the polysilicon deposited on the susceptor is easily peeled off.

Note that, since the wafer is more likely to adhere to a contact surface of the susceptor, the SiC particles having a flat surface on the CVD-SiC film more preferably have a flat surface of 100,000 µm² or less.

In this regard, the "SiC particle having a flat surface of at least 3,600 µm²" refers to a particle having a flat crystal surface extracted using image analysis software based on three-dimensional shape data acquired by using a laser microscope among the SiC particles exposed on the surface of the CVD-SiC film. The area of the flat surface is an area when the flat surface is projected onto an XY plane, and is calculated as an average value of projected areas measured by the same method for a plurality of SiC particles.

In this regard, in the CVD-SiC film, as shown in (a) of Fig. 2, the SiC particles preferably grow in a columnar shape from the surface of the substrate. Note that, (b) of Fig. 2 shows the case of a general CVD-SiC film.

In this manner, since the SiC particles in the CVD-SiC film grow in a columnar shape from the surface of the substrate, a flat surface is easily obtained on the surface of the CVD-SiC film.

In order to grow the SiC particles in the CVD-SiC film in a columnar shape from the surface of the substrate, the SiC particles can be grown in a columnar shape from the surface of the substrate by introducing a raw material gas (SiH₄ and CH₄) and a carrier gas while raising the temperature.

In this regard, the CVD-SiC film is preferably an unprocessed surface. When the surface of the CVD-SiC film is processed by machining or the like in order to form the flat surface as described above, a fracture layer is formed or a crystal plane orientation is changed, so that the CVD-SiC film becomes weak against chemical erosion or the polysilicon enters irregularities of the processed surface and is difficult to remove.

Note that, the unprocessed surface refers to a surface not subjected to machining such as polishing, grinding, or blasting.

Further, it is more preferable that the surface of the CVD-SiC film is an unprocessed surface, the average particle diameter of the SiC particles in the CVD-SiC film is at least 80 µm, the surface roughness Sa of the CVD-SiC film is at least 4.0 µm, and the CVD-SiC film contains SiC particles having a flat surface of at least 5,000 µm². Accordingly, in the step of forming the epitaxial film on the wafer, the polysilicon deposited on the SiC film can be easily and completely removed from the SiC film.

In addition, when the susceptor in the present invention is used, a high quality epitaxial layer can be obtained.

Note that, the CVD-SiC film is preferably formed at least on an outer surface of the substrate on which the wafer is placed, and more preferably formed on the entire outer surface of the substrate.

In the above embodiment, the susceptor has been described as an example of the semiconductor heat treatment member according to the present invention. However, the present invention is not limited to this form, and can be widely applied to a semiconductor heat treatment member in which the SiC film is formed on a surface of a carbon or silicon carbide substrate.

### EXAMPLES

Hereinafter, the present invention will be specifically described based on Examples, but the present invention is not limited to the Examples shown below.

### [Example 1]

A purification treatment was performed on isotropic high purity graphite (manufactured by CoorsTek KK) to reduce an impurity concentration (metal elements such as Fe, Ni, or Cr) in a carbon substrate to 0.05 ppm or less, to obtain a substrate.

A SiC film was formed on the above carbon substrate by using a CVD apparatus. In the CVD apparatus, the carbon substrate was placed in a chamber, and after the pressure was lowered to 0.1 Torr or less using a vacuum pump, a carrier gas (H₂) was introduced.

Next, the temperature inside the chamber was raised to 1,200°C. When the temperature inside the chamber was raised from 1,200°C to 1,300°C, raw material gases (SiH₄ and CH₄) and the carrier gas were introduced over 25 minutes. Thereafter, the keep coating was performed at 1,300°C and 0.20 Torr for 11 hours. After the keep coating, only N₂ was introduced to lower the temperature.

With the above procedure, the carbon substrate was covered with a CVD-SiC film. This procedure was repeated five times to obtain a CVD-SiC film having a SiC film thickness of 144 µm, a SiC average particle diameter of 80 µm, a SiC surface roughness Sa of 5.0 µm, and a flat surface area of SiC particles having a flat surface of 5,500 µm².

Note that, the SiC film thickness was measured in a non-contact manner using an eddy current film thickness measuring device. The SiC average particle diameter was determined by measuring the particle diameter using a laser microscope. The SiC surface roughness Sa was measured using a laser microscope. The area of the flat surface of the SiC particles having a flat surface was measured using a laser microscope.

The state of the particles on the surface of the SiC film is shown in Fig. 1. Fig. 1 is a photograph taken by SEM, in which reference numeral 1 denotes SiC particles and reference numeral 2 denotes grain boundaries between the SiC particles.

Then, polysilicon was deposited and removed under the following conditions. As the polysilicon deposition conditions, the temperature of the semiconductor heat treatment member was set to 1,150°C, and a silicon raw material gas such as trichlorosilane (SiHCl₃) was circulated for 120 seconds.

As the polysilicon removal conditions, the temperature of the semiconductor heat treatment member was set to 1,200°C, and a hydrogen chloride and hydrogen gas atmosphere was circulated for 60 seconds.

A degree of removal of the polysilicon from a semiconductor treatment member from which the polysilicon was removed was evaluated.

The degree of removal of the polysilicon was evaluated by evaluating the presence or absence of the polysilicon using SEM and EPMA. The results are shown in Table 1.

### [Example 2]

A substrate same as the substrate in Example 1 was used. Next, the temperature raising conditions to 1,100°C were also the same as in Example 1. When the temperature inside the chamber was raised from 1,100°C to 1,200°C, raw material gases (SiH₄ and CH₄) and the carrier gas were introduced over 25 minutes. The keep coating was performed at 1,200°C under 0.20 Torr for 11 hours. The temperature lowering conditions were also the same as in Example 1.

With the above procedure, the carbon substrate was covered with a CVD-SiC film. This procedure was repeated four times to obtain a CVD-SiC film having a SiC film thickness of 137 µm, the number of SiC layers of 4, a SiC average particle diameter of 60 µm, a SiC surface roughness Sa of 3.5 µm, and a flat surface area of SiC particles having a flat surface of 3,600 µm².

Then, the polysilicon was deposited and removed in the same manner as in Example 1.

Then, the degree of removal of the polysilicon from a semiconductor treatment member from which the polysilicon was removed was evaluated.

The degree of removal of the polysilicon was evaluated by evaluating the presence or absence of the polysilicon using SEM and EPMA. The results are shown in Table 1.

### [Comparative Example 1]

A substrate same as the substrate in Example 1 was used. Next, the temperature raising conditions were also the same as in Example 1. The keep coating was performed at 1,300°C under 0.20 Torr for 11 hours. The temperature lowering conditions were also the same as in Example 1. With the above procedure, the carbon substrate was covered with a CVD-SiC film. This procedure was repeated five times. Thereafter, the SiC surface was planarized by machining.

The SiC film thickness was 120 µm, the number of SiC layers was 5, the SiC average particle diameter was 80 µm, the SiC surface roughness Sa was 0.9 µm, and the flat surface area of the SiC particles having a flat surface was 100,000 m². Note that, since the surface of the SiC film was planarized by machining, it is considered that the flat surface area was increased even under the same conditions as in Example 1.

Then, the polysilicon was deposited and removed in the same manner as in Example 1.

Then, the degree of removal of the polysilicon from a semiconductor treatment member from which the polysilicon was removed was evaluated.

The degree of removal of the polysilicon was evaluated by evaluating the presence or absence of the polysilicon using SEM and EPMA. The results are shown in Table 1.

### [Comparative Example 2]

A substrate same as the substrate in Example 1 was used. Next, the temperature raising conditions were also the same as in Example 1. The keep coating was performed at 1,200°C under 0.20 Torr for 11 hours. The temperature lowering conditions were also the same as in Example 1. With the above procedure, the carbon substrate was covered with a CVD-SiC film. This procedure was repeated twice to obtain a CVD-SiC film having a SiC film thickness of 102 µm, the number of SiC layers of 2, a SiC average particle diameter of 40 µm, a SiC surface roughness Sa of 2.2 µm, and a flat surface area of SiC particles having a flat surface of 900 µm².

Then, the polysilicon was deposited and removed in the same manner as in Example 1.

Then, the degree of removal of the polysilicon from a semiconductor treatment member from which the polysilicon was removed was evaluated.

The degree of removal of the polysilicon was evaluated by evaluating the presence or absence of the polysilicon using SEM and EPMA. The results are shown in Table 1.

Note that, it is considered that since the keep coating temperature is lower and the number of repetitions of the coating is smaller than those in Example 1, the average particle diameter is smaller, and when the average particle diameter is smaller, the flat surface area and the surface roughness are also smaller.

### [Comparative Example 3]

A substrate same as the substrate in Example 1 was used. Next, the temperature raising conditions were also the same as in Example 1. The keep coating was performed at 1,100°C under 0.20 Torr for 11 hours. The temperature lowering conditions were also the same as in Example 1. With the above procedure, the carbon substrate was covered with a CVD-SiC film (only one coating).

Then, a CVD-SiC film having a SiC film thickness of 122 µm, a SiC average particle diameter of 10 µm, a SiC surface roughness Sa of 1.2 µm, and a flat surface area of SiC particles having a flat surface of 30 µm² was obtained.

Then, the polysilicon was deposited and removed in the same manner as in Example 1.

Then, the degree of removal of the polysilicon from a semiconductor treatment member from which the polysilicon was removed was evaluated.

The degree of removal of the polysilicon was evaluated by evaluating the presence or absence of the polysilicon using SEM and EPMA. The results are shown in Table 1.

Note that, it is considered that since the keep coating temperature is lower and the number of repetitions of the coating is smaller than those in Example 1, the average particle diameter is smaller, and when the average particle diameter is smaller, the flat surface area and the surface roughness are also smaller.

**[Table 1]**

| | CVD-SiC film | | | | | Evaluation | |
|---|---|---|---|---|---|---|---|
| | CVD-SiC film surface | Average particle diameter (µm) of SiC particles | Surface roughness Sa (µm) | Flat surface area (µm²) in present SiC particles | Thickness (µm) | Presence of polysilicon after removal | |
| Example 1 | Unprocessed surface | 80 | 5 | 5500 | 144 | A | A: complete removal is observed using SEM and EPMA. |
| Example 2 | Unprocessed surface | 60 | 3.5 | 3600 | 137 | B | B: polysilicon is observed in some grain boundaries and valleys between particles using SEM and EPMA. |
| Comparative Example 1 | Processed surface (machining) | 80 | 0.9 | 100000 | 120 | D | D: a large amount of polysilicon is observed using SEM and EPMA (polysilicon is observed not only at grain boundaries and in valleys between particles but also on SiC particles). |
| Comparative Example 2 | Unprocessed surface | 40 | 2.2 | 900 | 102 | C | C: polysilicon is observed in grain boundaries and valleys between particles using SEM and EPMA. |
| Comparative Example 3 | Unprocessed surface | 10 | 1.2 | 30 | 122 | D | D: a large amount of polysilicon is observed using SEM and EPMA (polysilicon is observed not only at grain boundaries and in valleys between particles but also on SiC particles). |

It is possible to easily remove, from the SiC film in the present invention, deposited polysilicon that causes a decrease in yield of the Si epitaxial process or a decrease in quality of the epitaxial layer.

Accordingly, it is possible to greatly reduce a semiconductor production cost and to produce a high quality Si wafer, thereby contributing to further improving performance of a semiconductor device.

### [Explanations of Reference numerals]

- 1: SiC particles
- 2: grain boundaries between the SiC particles
- 3: grain boundaries between the SiC particles

## Claims

1. A semiconductor heat treatment member comprising:
a substrate comprising carbon or silicon carbide; and
a CVD-SiC film with which a surface of the substrate is covered, wherein
a surface of the CVD-SiC film is an unprocessed surface,
the CVD-SiC film has an average particle diameter of SiC particles of at least 60 µm, and
the CVD-SiC film has a surface roughness Sa of at least 3.5 µm, and contains SiC particles having a flat surface of at least 3,600 µm².

2. The semiconductor heat treatment member according to claim 1, wherein the CVD-SiC film has the SiC particles grown in a columnar shape from the surface of the substrate.
